# EUROPEAN PATENT APPLICATION

(11) **EP 4 597 563 A1**
(43) Date of publication of application: **06.08.2025**
(21) Application number: 23872063.5
(22) Date of filing: 20.09.2023
(51) Int. Cl.: H01L 23/15, C03B 33/09, C03C 15/00, H05K 1/02

(54) **GLASS SUBSTRATE AND METHOD FOR MANUFACTURING GLASS SUBSTRATE**

(30) Priority: 29.09.2022 JP 2022156539
(71) Applicant: Nitto Denko Corporation, Ibaraki-shi, Osaka 567-8680 (JP)
(72) Inventor: MURASHIGE, Takeshi, Ibaraki-shi, Osaka 567-8680 (JP)
(74) Representative: Hoffmann Eitle
(86) International application number: PCT/JP2023/034022
(87) International publication number: WO 2024/070835

(57) **Abstract**

A glass substrate has a glass layer and an opening that is open on a first main surface side of the glass layer. A thickness of the glass layer is 10 µm or more and 300 µm or less, and an edge portion, on the first main surface side, of the opening has no burrs.

## Description

### TECHNICAL FIELD

The present invention relates to a glass substrate and a method of manufacturing the glass substrate.

### BACKRGOUND ART

In related arts, a composite substrate in which glass fiber is impregnated with epoxy resin could be used as a base substrate for a circuit board. However, as circuit becomes highly integrated, there has been a demand for reduction in thickness of the substrate, high dimensional stability of the substrate and insulation properties of the substrate. Therefore, it has been considered to apply a glass substrate where through holes are provided on a thin glass layer by laser processing to a glass interposer or a package substrate of a ball grid array (BGA).

### CITATION LIST

### PATENT DOCUMENT

Patent Document 1: Japanese Unexamined Patent Application Publication No. 2018-24563

### SUMMARY OF THE INVENTION

### TECHNICAL PROBLEM

However, when forming the through hole on the thin glass layer by the laser processing, an edge portion of an opening of the through hole does not have a smooth shape, but has a shape having burrs. If the burrs exist, stress concentrates on those parts, and a mechanical strength of the glass substrate is consequently reduced.

The present invention was made in view of the above points, and an object of the present invention is to improve the mechanical strength of the glass substrate having the glass layer on which the opening is formed.

### SOLUTION TO PROBLEM

The present glass substrate comprises: a glass layer; and an opening that is open on a first main surface side of the glass layer, wherein a thickness of the glass layer is 10 µm or more and 300 µm or less, and an edge portion, on the first main surface side, of the opening has no burrs.

### EFFECT OF INVENTION

According to technique of disclosure, it is possible to improve the mechanical strength of the glass substrate having the glass layer on which the opening is formed.

### BRIEF DESCRIPTION OF DRAWINGS

Fig. 1 is a cross-sectional view illustrating a glass substrate according to a first embodiment.
Fig. 2 is a partially enlarged cross-sectional view of openings 11 and 12 and their vicinities shown in Fig. 1.
Fig. 3 is a cross-sectional view (part 1) illustrating a manufacturing process of the glass substrate according to the first embodiment.
Fig. 4 is a cross-sectional view (part 2) illustrating a manufacturing process of the glass substrate according to the first embodiment.
Fig. 5 is a cross-sectional view illustrating a glass substrate according to a modification 1 of the first embodiment.
Fig. 6 is a cross-sectional view illustrating a glass substrate according to a modification 2 of the first embodiment.
Fig. 7 is a graph showing an evaluation result of a mechanical strength.
Fig. 8 is a graph showing distribution of aspect ratios of through holes formed.
Fig. 9 shows photographs of shapes of the openings and shapes of the through holes of sample numbers A to D of Fig. 8.
Fig. 10 shows photographs of shapes of the openings and shapes of the through holes of sample numbers E to H of Fig. 8.

### EMBODIMENTS FOR CARRYING OUT THE INVENTION

Embodiments for carrying out the invention will be described below with reference to the drawings. In each drawing, the same elements or components are denoted by the same reference signs, and their explanations may be omitted.

### <First Embodiment>

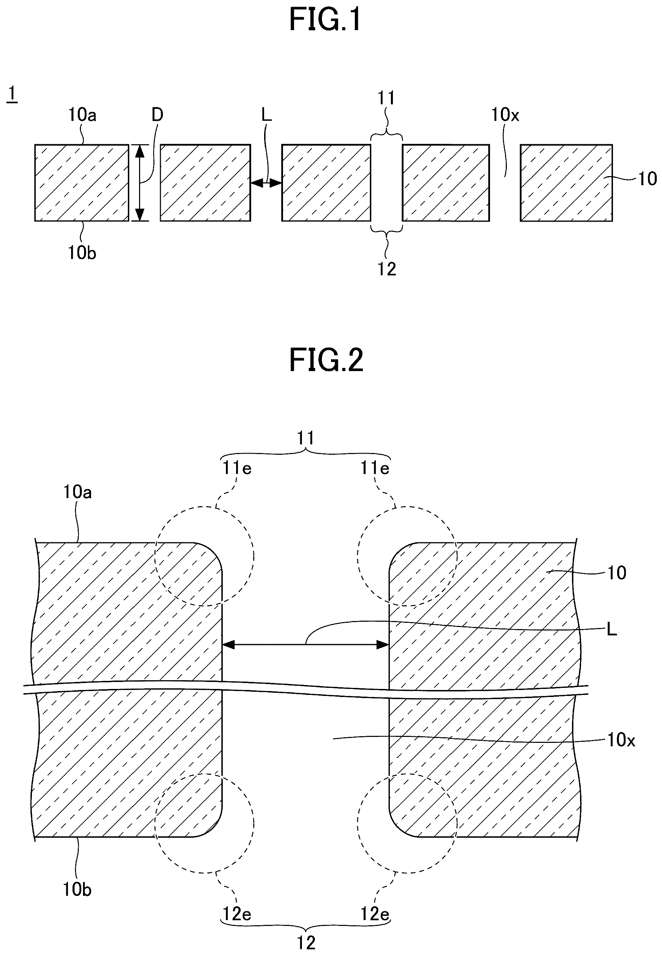

Fig. 1 is a cross-sectional view illustrating a glass substrate according to a first embodiment. As illustrated in Fig. 1, a glass substrate 1 has a glass layer 10, a through hole(s) 10x, an opening(s) 11, and an opening(s) 12. However, as long as the glass substrate according to the present has at least one opening, the glass substrate is not necessarily required to have a plurality of openings and a plurality of through holes. For instance, the glass substrate according to the present may have a bottomed groove having an opening instead of the through hole.

The glass layer 10 of the glass substrate 1 illustrated in Fig. 1 has a first main surface 10a, and a second main surface 10b that is an opposite surface to the first main surface 10a. The first main surface 10a and the second main surface 10b could be parallel to each other, or may not be parallel to each other.

The glass layer 10 is not particularly limited, and an appropriate glass layer could be used according to purposes. According to classification by composition, the glass layer 10 is, for instance, soda-lime glass, borate glass, aluminosilicate glass, quartz glass, etc. Further, according to classification by alkali component, for instance, a non-alkali glass and a low-alkali glass are cited. A content of alkali metal component (e.g. Na₂O, K₂O, Li₂O) of the above glasses is preferably 15 wt% or less, and more preferably 10 wt% or less.

In consideration of surface hardness, airtightness and corrosion resistance of the glass, a thickness of the glass layer 10 is preferably 10 µm or more. In addition, since it is desirable for the glass layer 10 to have flexibility like a film, the thickness of the glass layer 10 is preferably 300 µm or less. The thickness of the glass layer 10 is more preferably 20 µm or more and 200 µm or less, and particularly preferably 30 µm or more and 150 µm or less.

A molding method of the glass layer 10 is not particularly limited, and an appropriate method could be employed according to purposes. Typically, the glass layer 10 can be produced by melting (fusing) a mixture containing a main raw material such as silica and alumina, a defoaming agent such as mirabilite (sodium sulfate) and antimony oxide, and a reducing agent such as carbon at a temperature of about 1400 °C to 1600 °C, molding the mixture into a thin plate shape, and then cooling it. As the molding method of the glass layer 10, for instance, a slot downdraw method, a fusion method, a float method, etc. are cited. The glass layer molded into the plate shape by these methods may be chemically polished, as necessary, with a solvent such as hydrofluoric acid in order to reduce a thickness of the plate-shaped glass layer or increase its smoothness.

The through hole(s) 10x is formed in a direction substantially perpendicular to the first main surface 10a on the glass layer 10. The through hole 10x may be arranged, for instance, two-dimensionally in vertical and horizontal directions when viewed from a normal direction of the first main surface 10a, or arranged at an arbitrary position. The through hole 10x has the opening 11 and the opening 12. The opening 11 is located at one end of the through hole 10x, and is open to the first main surface 10a side of the glass layer 10. The opening 12 is located at the other end of the through hole 10x, and is open to the second main surface 10b side of the glass layer 10.

A shape of the through hole 10x is, for instance, a circular shape or an elliptic shape when viewed from the normal direction of the first main surface 10a. The shape of the through hole 10x when viewed from the normal direction of the first main surface 10a could be a deformed shape similar to the circular shape or the elliptic shape. Alternatively, the shape of the through hole 10x when viewed from the normal direction of the first main surface 10a may be a rectangular shape, a trapezoidal shape or other arbitrary shape.

An opening width L of the through hole 10x when viewed from the normal direction of the first main surface 10a is, for instance, preferably 5 µm or more and 1000 µm or less, and more preferably 10 µm or more and 500 µm or less. A pitch of the through holes 10x is, for instance, preferably 5 µm or more and 5000 µm or less, and more preferably 100 µm or more and 1000 µm or less.

It is noted that when the shape of the through hole 10x when viewed from the normal direction of the first main surface 10a is the circular shape, the opening width L of the through hole 10x is a diameter. When the shape of the through hole 10x when viewed from the normal direction of the first main surface 10a is the elliptic shape, the opening width L of the through hole 10x is a major axis. Also, when the shape of the through hole 10x when viewed from the normal direction of the first main surface 10a is the rectangle or a square, the opening width L of the through hole 10x is a length of a diagonal line. Further, when the shape of the through hole 10x when viewed from the normal direction of the first main surface 10a is a shape other than these shapes, a length of the longest straight line that can be continuously drawn within the shape of the through hole 10x when viewed from the normal direction of the first main surface 10a is defined as the opening width L of the through hole 10x.

A depth D of the through hole 10x is the same as the thickness of the glass layer 10. An aspect ratio of the through hole 10x is defined by an expression "the aspect ratio = the depth D / the opening width L". The aspect ratio of the through hole 10x can be, for instance, approximately 3 or more and 9 or less. In consideration of ease of forming of the through hole 10x, the aspect ratio of the through hole 10x is preferably 3 or more and 6 or less.

Fig. 2 is a partially enlarged cross-sectional view of the openings 11 and 12 and their vicinities shown in Fig. 1. As illustrated in Fig. 2, there is no burrs at an edge portion 11e, on the first main surface 10a side, of the opening 11. Likewise, there is no burrs at an edge portion 12e, on the second main surface 10b side, of the opening 12. Here, the burrs refer to minute protrusions that produce unnecessary asperities generated on a processing surface.

As illustrated in Fig. 2, the edge portion 11e of the opening 11 and the edge portion 12e of the opening 12 each have, for instance, a rounded profile in cross section. Here, the rounded profile refers to a gentle shape having no thin sharp portion. For instance, the rounded profile could be an arc shape, or may be a curved shape close to an arc. A radius of curvature of the rounded profile is, for instance, preferably several nm or more and several tens of nm or less. The radius of curvature can be determined by image analysis of cross-sectional observation using an electron microscope or the like.

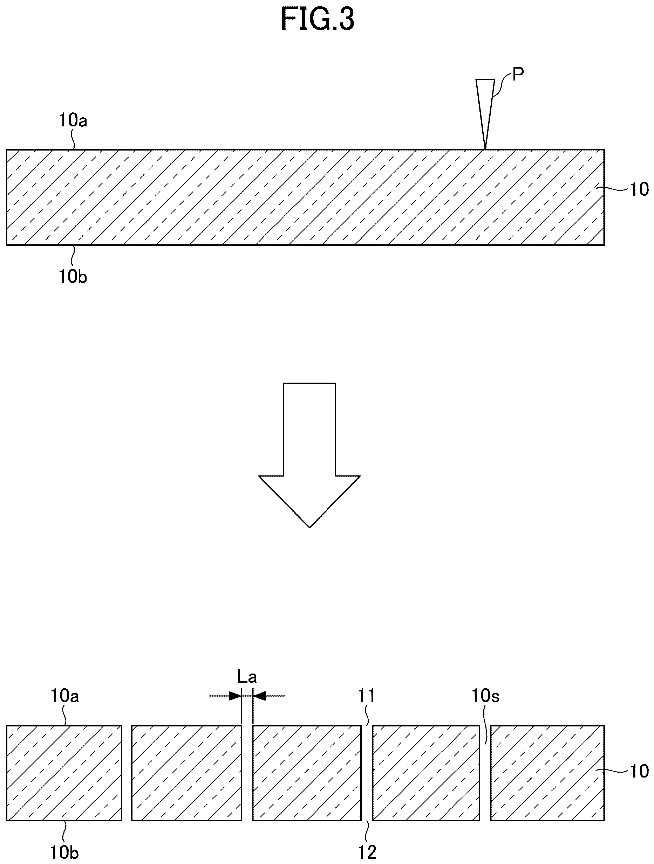

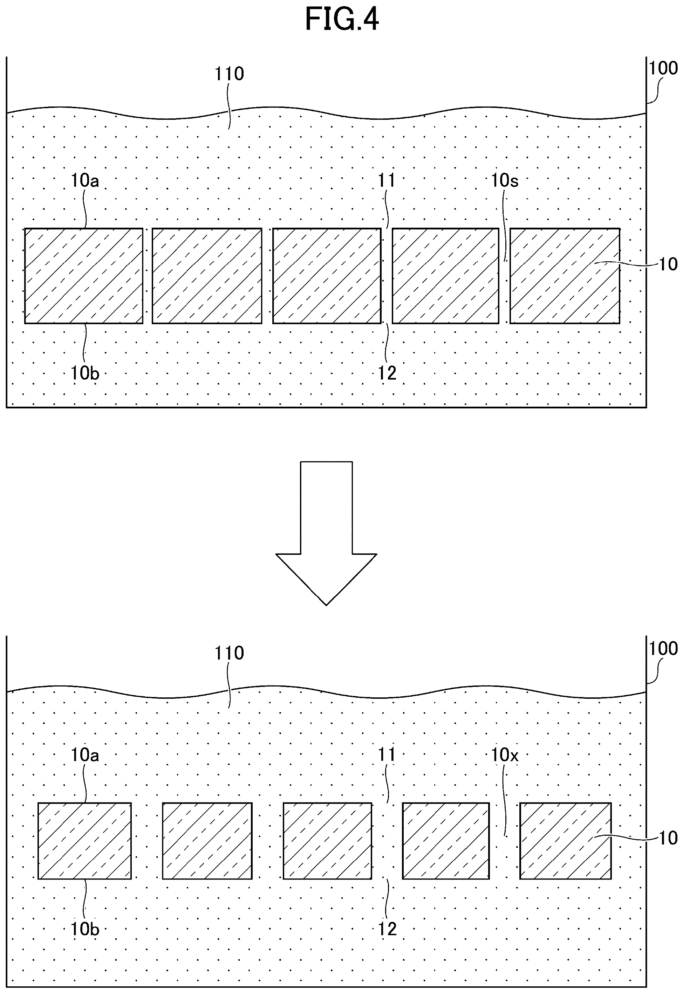

Figs. 3 and 4 are cross-sectional views illustrating a manufacturing process of the glass substrate according to the first embodiment. First, in the process illustrated in Fig. 3, the glass layer 10 is prepared, and a predetermined position on the first main surface 10a of the glass layer 10 is irradiated with a laser light P, then a seed hole 10s having the opening 11 opening to the first main surface 10a side and the opening 12 opening to the second main surface 10b side is formed.

It is preferable to use a pulse laser for the forming of the seed hole 10s. For instance, a femtosecond laser or a picosecond laser can be used. An opening width La of the seed hole 10s is small as compared with the opening width L of the through hole 10x finally formed of the glass substrate 1. It is noted that in this process, burrs may be formed at the edge portions of the opening 11 and the opening 12.

Next, in the process illustrated in Fig. 4, the entire glass layer 10 on which the opening 11, the opening 12 and the seed hole 10s have been formed in the process shown in Fig. 3 is put in an etching bath 100 provided with an etchant 110, and is wet-etched. For the wet etching, the etchant 110 containing, for instance, hydrofluoric acid can be used. Alternatively, other etchant capable of dissolving the glass layer 10 could be used.

In Fig. 4, an upper side of an arrow shows a state immediately after start of the etching, whereas a lower side of the arrow shows a state in which the etching is completed. As illustrated in Fig. 4, by wet-etching the entire glass layer 10, the entire glass layer 10 dissolves with the passage of time. Therefore, in the lower side of the arrow in Fig. 4, as compared with the upper side of the arrow, a thickness and a width of the glass layer 10 become smaller, and the seed hole 10s expands, then becomes the through hole 10x.

Further, since the edge portion, on the first main surface 10a side, of the opening 11 and the edge portion, on the second main surface 10b side, of the opening 12 also dissolve by the wet-etching, shapes of the edge portions after the wet-etching become, for instance, the rounded profile as shown in Fig. 2. Even if burrs exist at the edge portions of the opening 11 and the opening 12 in the process shown in Fig. 3, since the burrs dissolve and disappear by the wet-etching, the opening 11 and the opening 12 both having no burrs are formed in this process.

After the process shown in Fig. 4, by taking out the glass layer 10 from the etching bath 100 and drying the glass layer 10, the glass substrate 1 shown in Fig. 1 is completed.

As described above, by using the laser processing and the wet-etching in combination when forming the opening on the glass layer, the glass substrate having no burrs at the edge portion of the opening can be formed.

If the opening is formed by only the laser processing as in the related art, the shape of the edge portion of the opening does not become the rounded profile, and burrs arise at the edge portion of the opening. If the burrs arise at the edge portion of the opening, since stress concentrates on those parts, a mechanical strength in the vicinity of the opening of the glass substrate is reduced. Further, if the burrs arise at the edge portion of the opening, when a wiring layer is formed at a portion including the edge portion of the opening, there is a risk that the wiring layer will be broken.

In contrast to this, in the case of the glass substrate having the opening having no burrs described in the first embodiment, there is no part on which the stress concentrates. It is therefore possible to improve the mechanical strength of the glass substrate. Further, when the wiring layer is formed at the portion including the edge portion of the opening, the risk of breaking the wiring layer can be reduced. Hence, the glass substrate according to the first embodiment is quite suitable for application to a glass interposer or a package substrate of a ball grid array (BGA) on which a semiconductor chip is mounted.

Here, the glass substrate is superior to a resin substrate such as a glass epoxy substrate and a polyimide substrate in that the glass substrate has a low thermal expansion coefficient and high resistance. In addition, as compared with a silicon substrate, the glass substrate is excellent in upsizing of an area of the substrate and reduction in thickness of the substrate.

### <Modification of First Embodiment>

Modification of the first embodiment shows examples of the glass substrate where a shape of the hole formed on the glass layer is different. In the modification of the first embodiment, explanation of the same elements or components as those of the embodiment already described above may be omitted.

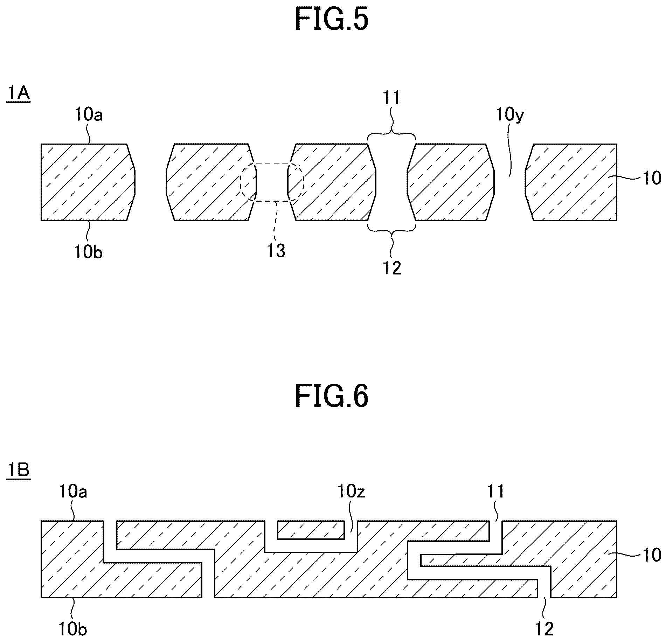

Fig. 5 is a cross-sectional view illustrating a glass substrate according to a modification 1 of the first embodiment. As illustrated in Fig. 5, a glass substrate 1A has a constricted portion 13 that communicates with the opening 11. That is, a through hole(s) 10y formed on the glass substrate 1A is narrow in the vicinity of a middle portion, in a thickness direction of the glass layer 10, of the through hole 10y. In the case of the through hole 10y as well, similar to Fig. 2, the edge portion of the opening 11 and the edge portion of the opening 12 each have, for instance, the rounded profile in cross section.

As in the glass substrate 1, the through hole 10x whose thickness (width) is substantially constant could be formed. Also, as in the glass substrate 1A, the through hole 10y which is narrow in the vicinity of its middle portion in the thickness direction of the glass layer 10 could be formed. If the aspect ratio is relatively high, the through hole tends to have a shape like the through hole 10y. If the aspect ratio is relatively low, the through hole tends to have a shape like the through hole 10x. In the case where the constricted portion 13 is formed as in the through hole 10y, when a through-hole interconnect that fills the through hole 10y is formed, the through-hole interconnect can be hindered from falling out of the through hole 10y. Further, when an easy-adhesion layer is formed on a surface of the glass layer 10 by vapor deposition etc., the vapor deposition is difficult on a vertical surface. However, if the through hole has a constricted shape, the vapor deposition to an inside of the through hole is relatively easy.

Fig. 6 is a cross-sectional view illustrating a glass substrate according to a modification 2 of the first embodiment. As illustrated in Fig. 6, a glass substrate 1B has a hole(s) 10z. The hole 10z is not a hole that penetrates the glass layer 10 in the direction substantially perpendicular to the first main surface 10a, but includes a vertical hole that extends in the direction substantially perpendicular to the first main surface 10a and a horizontal hole that extends in a direction substantially parallel to the first main surface 10a. The hole 10z may include a hole that extends in a direction inclining with respect to the first main surface 10a. In the case of the hole 10z as well, similar to Fig. 2, the edge portion of the opening 11 and the edge portion of the opening 12 each have, for instance, the rounded profile in cross section.

Holes of various shapes like the hole 10z can be formed on the glass layer 10. That is, since the glass layer 10 has high transparency, transmittance of the laser light is very high. Therefore, by condensing (focusing) the laser light at a desired position in the glass layer 10 to achieve a high energy density and performing three-dimensional scanning, a desired shaped seed hole can be formed. Subsequently, by performing the wet-etching similar to Fig. 4, the seed hole expands and becomes the hole 10z, then the glass substrate 1B can be obtained.

### [Evaluation of Mechanical Strength]

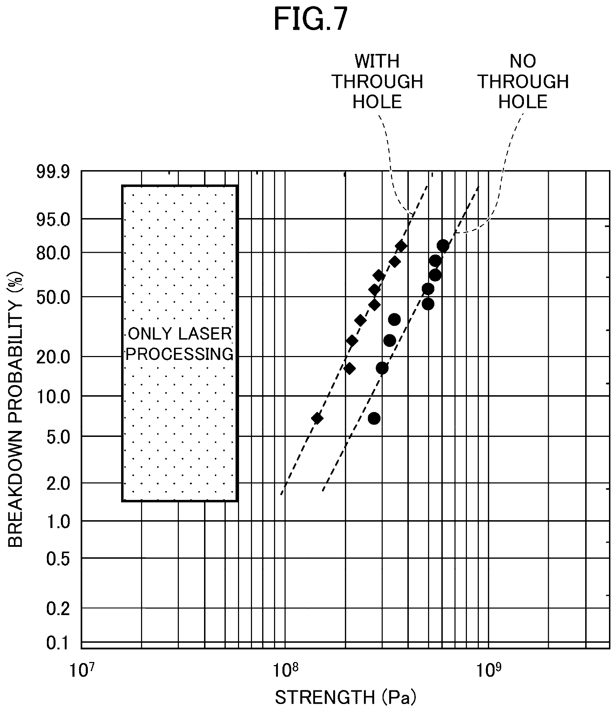

Weibull distributions of a glass substrate where through holes are formed on a 100um-thick glass layer and a glass substrate where through holes are not formed on a 100um-thick glass layer were obtained. Its result is shown in Fig. 7.

In Fig. 7, "NO THROUGH HOLE" represents Weibull distribution of the glass substrate where through holes are not formed at all on the 100um-thick glass layer. "WITH THROUGH HOLE" represents Weibull distribution of the glass substrate where circular through holes whose diameters are each 20 µm are formed at a pitch of 100 µm on the 100µm-thick glass layer by the method described with reference to Figs. 3 and 4. Further, "ONLY LASER PROCESSING" represents an area in which Weibull distribution of a glass substrate where through holes having the same diameter and the same pitch as those of "WITH THROUGH HOLE" are formed on a 100um-thick glass layer by only the laser processing without performing the wet-etching appears.

It is noted that the through holes formed by only the laser processing were straight in shape as shown in Fig. 1, and did not have the constricted portion. In addition, an edge portion of an opening of each through hole did not have the rounded profile as shown in Fig. 2, but had a shape having a sharp corner, and burrs were formed. In contrast to this, no burrs were formed at the through holes formed by the method described with reference to Figs. 3 and 4.

As illustrated in Fig. 7, it was confirmed that the glass substrate where the through holes were formed by using the wet-etching in combination with the laser processing had a higher mechanical strength than that of the glass substrate where the through holes were formed by only the laser processing, and had the mechanical strength that is close to a mechanical strength of a glass substrate where the through holes were not formed. This is believed that since burrs did not arise at the edge portions of the openings in the glass substrate where the through holes were formed by using the wet-etching in combination with the laser processing, reduction in mechanical strength due to the stress concentration caused by the existence of the burrs did not occur.

### [Aspect Ratio]

Through holes with different aspect ratios were formed on 100um-thick glass layers by the method described with reference to Figs. 3 and 4, and shapes of the openings and cross-sectional shapes of the through holes were checked. Here, the aspect ratio is adjustable by changing an etching rate when wet-etching the glass layer.

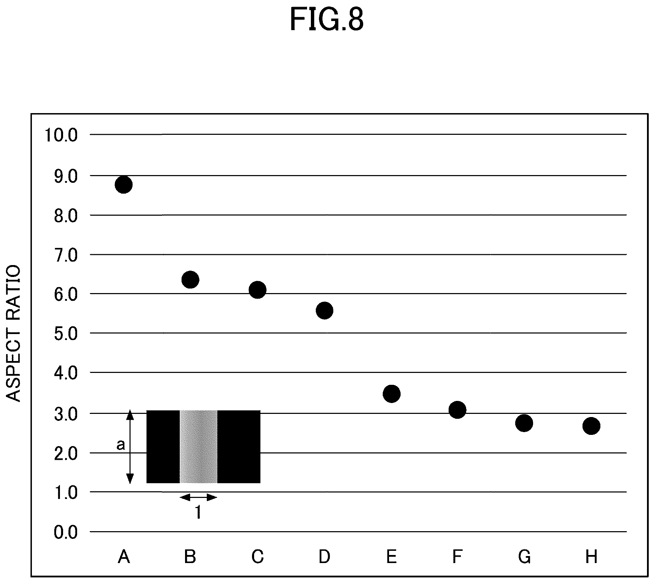

Fig. 8 is a graph showing distribution of aspect ratios of through holes formed. As illustrated in Fig. 8, in this experiment, through holes whose aspect ratios are about 3 to 9 were formed. Each aspect ratio shown in Fig. 8 is a value of the depth a of the through hole when normalizing the opening width of the through hole to 1. A to H shown in a horizontal axis of Fig. 8 are sample numbers.

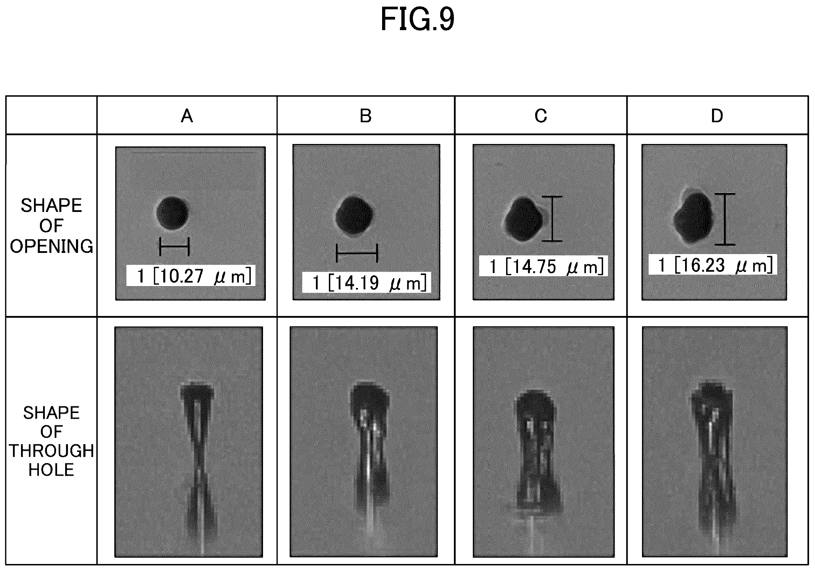

Fig. 9 shows photographs of the shapes of the openings and the shapes of the through holes of the sample numbers A to D of Fig. 8. As illustrated in Fig. 9, in the sample numbers A to D, the through holes are all formed. However, the constricted portion of the sample number A is extremely narrow. It is understood that when the aspect ratio approaches closer to 9, it is difficult to form the through hole.

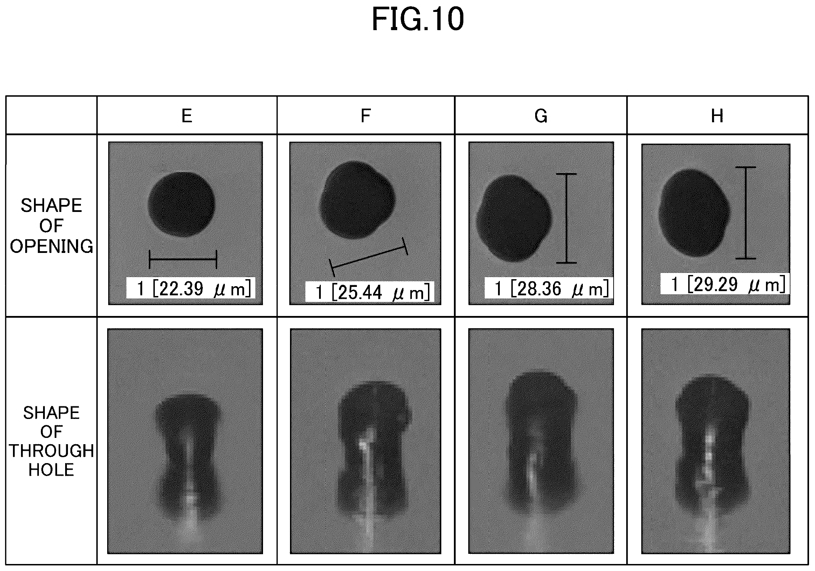

Fig. 10 shows photographs of the shapes of the openings and the shapes of the through holes of the sample numbers E to H of Fig. 8. As illustrated in Fig. 10, in the sample numbers E to H, the through holes are all formed. In the sample numbers E to H, there is no through hole whose constricted portion is extremely narrow as in the sample number A shown in Fig. 9. It can be said that from a result of Figs. 9 and 10, if the aspect ratio is 3 or more and 6 or less, the through hole can be stably formed.

Further, although control of the aspect ratio of the through hole formed by only the laser processing is difficult, the aspect ratio can be easily controlled by adjusting the etching rate in the method described with reference to Figs. 3 and 4, and a through hole having a relatively high aspect ratio of about 6 can also be formed.

Although the preferred embodiments have been described above in detail, the present invention is not limited to the above embodiments, and various modifications and substitutions can be made to the above embodiments without departing from the scope of the claims.

For instance, the opening may not have a shape that is closed when viewed from the normal direction of the first main surface 10a. For instance, when cutting the glass layer 10 shown in Fig. 3 into two regions by the laser light P, edge portions on the first main surface side and the second main surface side of cutting surfaces are also edge portions of the opening. In this case as well, by performing the wet-etching in the process of Fig. 4, the edge portions of the opening (i.e. the edge portions on the first main surface side and the second main surface side of cutting surfaces) have the rounded profile as shown in Fig. **2****.** As a result, it is possible to improve the mechanical strength of the glass substrate.

In addition to the above embodiment, the following supplementary clauses are disclosed.

### (Clause 1)

A glass substrate comprising:
a glass layer; and
an opening that is open on a first main surface side of the glass layer,
wherein a thickness of the glass layer is 10 µm or more and 300 µm or less, and
an edge portion, on the first main surface side, of the opening has no burrs.

### (Clause 2)

The glass substrate as described in clause 1, wherein the edge portion, on the first main surface side, of the opening has a rounded profile in a cross-sectional view.

### (Clause 3)

The glass substrate as described in clause 1 or 2, further comprising a constricted portion that communicates with the opening.

### (Clause 4)

The glass substrate as described in any one of the preceding clauses 1 to 3, further comprising a hole having the opening,
wherein an aspect ratio of the hole is 3 or more and 6 or less.

### (Clause 5)

The glass substrate as described in clause 4, wherein
the hole has a second opening that is open on a second main surface side opposite to the first main surface, and
an edge portion, on the second main surface side, of the second opening has no burrs.

### (Clause 6)

A method of manufacturing a glass substrate comprising:
a process of forming an opening that is open on a first main surface side of a glass layer by irradiating a first main surface of the glass layer with laser light; and
a process of etching the glass layer on which the opening is formed,
wherein a thickness of the glass layer is 10 µm or more and 300 µm or less, and
an edge portion, on the first main surface side, of the opening after the process of performing the etching has no burrs.

### (Clause 7)

The method of manufacturing the glass substrate as described in clause 6, wherein
a femtosecond laser is used in the process of forming the opening, and
an etchant containing hydrofluoric acid is used in the process of performing the etching.

The present international application is based on and claims priority to Japanese patent application No. 2022-156539 filed on September 29, 2022 with the Japanese Patent Office, the entire contents of which are hereby incorporated by reference.

### DESCRIPTION OF REFERENCE SYMBOLS

1, 1A, 1B glass substrate
10 glass layer
10a first main surface
10b second main surface
10s seed hole
10x, 10y through hole
10z hole
11, 12 opening
11e, 12e edge portion of opening
13 constricted portion
100 etching bath
110 etchant

## Claims

1. A glass substrate comprising:
a glass layer; and
an opening that is open on a first main surface side of the glass layer,
wherein a thickness of the glass layer is 10 µm or more and 300 µm or less, and
an edge portion, on the first main surface side, of the opening has no burrs.

2. The glass substrate as claimed in claim 1,
wherein the edge portion, on the first main surface side, of the opening has a rounded profile in a cross-sectional view.

3. The glass substrate as claimed in claim 1,
further comprising a constricted portion that communicates with the opening.

4. The glass substrate as claimed in claim 1,
further comprising a hole having the opening,
wherein an aspect ratio of the hole is 3 or more and 6 or less.

5. The glass substrate as claimed in claim 4,
wherein
the hole has a second opening that is open on a second main surface side opposite to the first main surface, and
an edge portion, on the second main surface side, of the second opening has no burrs.

6. A method of manufacturing a glass substrate
comprising:
a process of forming an opening that is open on a first main surface side of a glass layer by irradiating a first main surface of the glass layer with laser light; and
a process of etching the glass layer on which the opening is formed,
wherein a thickness of the glass layer is 10 µm or more and 300 µm or less, and
an edge portion, on the first main surface side, of the opening after the process of performing the etching has no burrs.

7. The method of manufacturing the glass substrate
as claimed in claim 6, wherein
a femtosecond laser is used in the process of forming the opening, and
an etchant containing hydrofluoric acid is used in the process of performing the etching.
